(19) Europäisches Patentamt

European Patent Office

Office européen des brevets

(11) **EP 1 245 080 B1**

(12) **EUROPEAN PATENT SPECIFICATION**

(45) Date of publication and mention
of the grant of the patent:
**22.10.2003 Bulletin 2003/43**

(51) Int Cl.⁷: **H03H 11/04**, H03H 11/22

(21) Application number: **00978870.4**

(22) Date of filing: **22.11.2000**

(86) International application number:
**PCT/US00/32219**

(87) International publication number:
**WO 01/039372 (31.05.2001 Gazette 2001/22)**

(54) **AN ACTIVE POLYPHASE FILTER WITH TRANSCONDUCTOR CROSS-COUPLING OF FILTER SECTIONS**

AKTIVES POLYPHASENFILTER MIT TRANSKONDUKTORKREUZKOPPLUNG VON FILTERSEKTIONEN

FILTRE ACTIF POLYPHASE AVEC COUPLAGE CROISE DE TRANSDUCTEUR ENTRE LES PARTIES DU FILTRE

(84) Designated Contracting States:
**DE FR GB IT**

(30) Priority: **23.11.1999 US 167188 P**

(43) Date of publication of application:
**02.10.2002 Bulletin 2002/40**

(73) Proprietor: **MICRO LINEAR CORPORATION**
**San Jose, CA 95131 (US)**

(72) Inventors:
• **VINN, Charles**
**Milpitas, CA 95035 (US)**
• **LUFF, Gwilym**
**Cambridge, CB2 5UT (GB)**
• **LABER, Carlos**
**Los Altos, CA 94022 (US)**

(74) Representative: **Bluff, John William et al**
**Lloyd Wise**
**Commonwealth House,**
**1-19 New Oxford Street**
**London WC1A 1LW (GB)**

(56) References cited:
**EP-A- 0 344 852**          **US-A- 5 245 565**

**Description**

FIELD OF INVENTION:

The present invention relates to the field of active polyphase filter design. More particularly, the invention relates to the use of transconductors to cross-couple active polyphase filters sections.

BACKGROUND OF THE INVENTION:

Polyphase filters receive an N-phase (or polyphase) input signal and create an N-phase output signal. A quadrature filter is a four-phase polyphase filter. In a quadrature filter, the input will consist of four signal voltages of mutually equal value. These four input signals jointly constituting a signal vector group with the individual signal vectors succeeding one another in a given direction of rotation through phase angles of 90 degrees. Dependent on direction of rotation, counter-clockwise or clockwise, the frequency of the polyphase signal is positive or negative. The 0 degree and 180 degree signal vectors are designated the +I and -I signals. The 90 degree and 270 degree signal vectors are designated the +jQ and -jQ signals. Such a polyphase filter is known from the article "Asymmetric Polyphase Networks" by M. J. Gingell, published in "Electrical Communication", Vol. 48, no. 1 and 2, 1973, pp. 21-25.

Passive LC filters are limited by the difficulty of incorporating inductors into integrated circuits. To replace inductors and reduce sensitivity to component variations, active-RC filters were introduced. Operational amplifiers and, in some designs, gyrators are the reactances in an active-RC design. Active-RC filter circuits are easier to design and manufacture than passive filters. Feedback loops between the inputs and outputs of the active-RC reactances replace the need for inductive elements and reduce sensitivity to component variation.

The conversion of passive-LC filters designs to active-RC filter designs, termed "filter design," is the subject of many publications. Filter design begins with the choice of a passive filter. The most common types of passive filters are the gaussian, Butterworth, Bessel, and Chebyshev filters. The type of passive filter is chosen based upon its characteristics, such as ripple, stopband rejection, pole quality factor, noise figure, and sensitivity. The order of the filter, an indication of the number of poles in the filter, is also chosen. The choice of filter type and order is based on the constraints of the intended manufacturing process and end-use. After a filter type and order are chosen, nodal transfer functions (generally represented in Laplace notation) for the filter are derived. The nodal transfer functions allow a signal flow graph of the passive filter to be mapped. The nodal transfer functions of the passive filter are then replaced with active elements, resistors, and capacitors. The resulting active-RC filter network has a filter transfer function equivalent to the passive filter.

Three books that demonstrate filter design techniques are: (i) Handbook of Filter Synthesis, by Anatol I. Zverev, published 1967 by John Wiley & Sons; (ii) Electronic Filter Design Handbook, by Arthur B. Williams, published 1995 by McGraw Hill; and (iii) Analog MOS Integrated Circuits for Signal Processing, by Roubik Gregorian and Gabor C. Temes, published 1986 by John Wiley & Sons. In these books, schematics and tables of figures detail the configuration and component values for a broad range of filter types and orders. A detailed example of filter design can also be found in the following U.S. Patents: (i) "Symmetrical Polyphase Networks Utilizing Constant Reactances" by Michael John Gingell, number 3,618,133, issued 1971; and (ii) "Asymmetric Polyphase Filter" by Johannes O. Voorman, number 4,914,408, issued 1990 (hereafter "Voorman Patent"). Computer programs for filter design are also available.

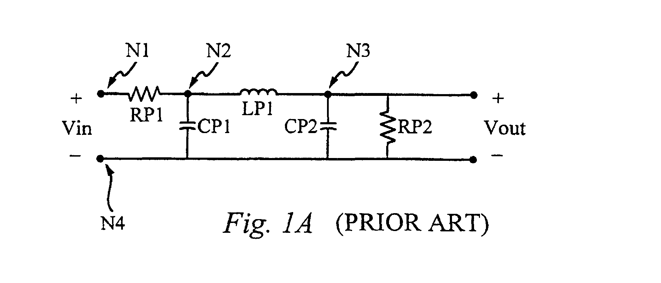

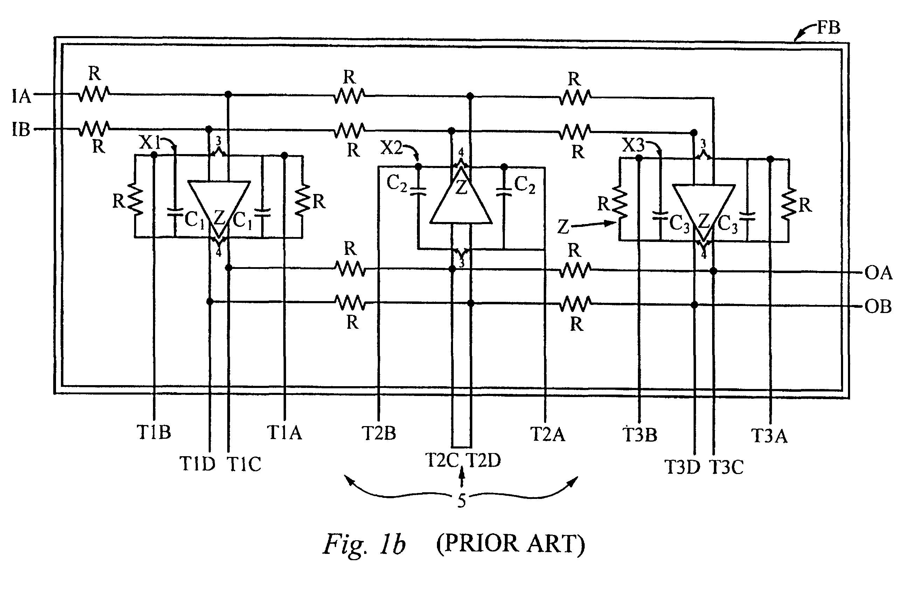

An example of filter design is illustrated in Figures 1A and 1B. Figure 1A shows a low-pass third-order passive LC filter 1 with four nodes, N1, N2, N3, and N4, numbered sequentially clockwise from the top left. The input voltage Vin is applied across N1 and N4. The output voltage Vout is measured across N3 and N4. A first resistor RP1 is connected between N1 and N2. A first capacitor CP1 is connected between N2 and N4. An inductor LP1 is connected between N2 and N3. A second capacitor CP2 and a second resistor RP2 are connected in parallel across N3 and N4.

Figure 1B shows a low-pass third-order active-RC filter block (hereafter "FB") that approximates the transfer function of the low-pass third-order passive LC filter shown in Figure 1A. FB includes: two input terminals IA and IB; two output terminals OA and OB; three reactances X1, X2, and X3; and fourteen matched resistors R. Each reactance is an active balanced integrating circuit than includes: one balanced differential amplifier 2, a reactance input pair 3; a reactance output pair 4; and a matched capacitor pair C1, C2, and C3. In each matched capacitor pair: one capacitor is shunted between the first input of a reactance input pair 3 and the first output of the reactance output pair 4; and the other capacitor is shunted between the second input of the reactance input pair 3 and the second output of the reactance output pair 4.

The internal nodes of FB can be identified by their associated terminal 5, as set forth in below Table I below.

TABLE I:

| FB Nodes Identified by Terminal Number | | | |
|---|---|---|---|
| Reactance | First/Second | Input/Output | Terminal |
| X1 | second | input | T1A |
| X1 | first | input | T1B |
| X1 | second | output | T1C |
| X1 | first | output | T1D |
| X2 | second | output | T2A |
| X2 | first | output | T2B |
| X2 | first | input | T2C |
| X2 | second | input | T2D |
| X3 | second | input | T3A |
| X3 | first | input | T3B |
| X3 | second | output | T3C |
| X3 | first | output | T3D |

Note also that output terminal OA is attached to terminal T3C and that output OB is attached to terminal T3D. The Table II netlist below indicates the location of the fourteen matched resistors R. In table II, one matched resistor R is connected between the first node and the second node.

TABLE II:

| Resistors Connected Within FB | |
|---|---|
| First Node | Second Node |
| IA | T1A |
| IB | T1B |
| T1A | T2A |
| T1B | T2B |
| T1C | T2C |
| T1D | T2D |
| T2A | T3A |
| T2B | T3B |
| T2C | T3C |
| T2D | T3D |
| T1A | T1C |
| T1B | T1D |
| T3A | T3C |
| T3B | T3D |

While resistors R are shunted across X1 and X3, no resistors R are shunted across X2.

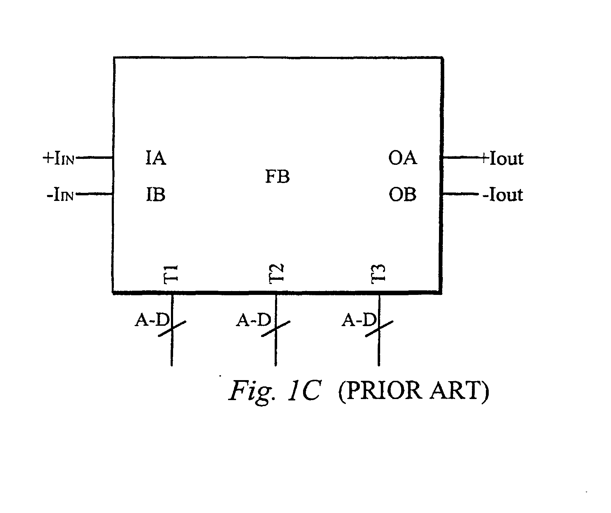

Figure 1C shows a block diagram of FB. The block diagram has two inputs IA and IB. The block diagram has two outputs OA and OB. The block diagram also has three sets of four-lead terminals T1-T3 for a total of twelve terminals. The first set is labeled T1 and is composed of four terminals T1A, T1B, T1C, and T1D. The second set is labeled T2 and is composed of four terminals T2A, T2B, T2C, and T2D. The third set is labeled T3 and is composed of four terminals T3A, T3B, T3C, and T3D. Figure 1C also demonstrates how FB can be attached to a 2-phase input +Iin and -Iin, by input terminals IA and IB respectively, to generate a 2-phase output +Iout and -Iout, through output terminals OA and OB respectively.

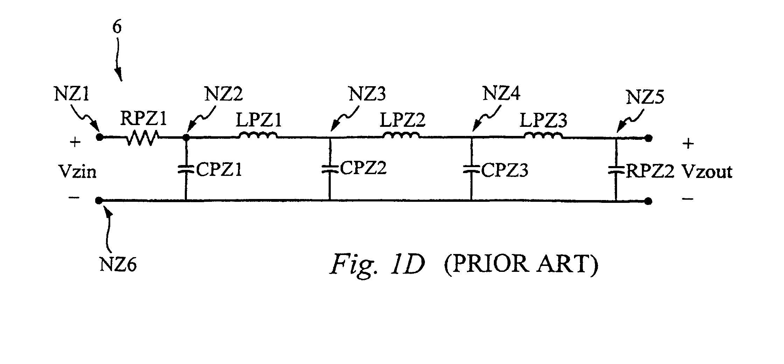

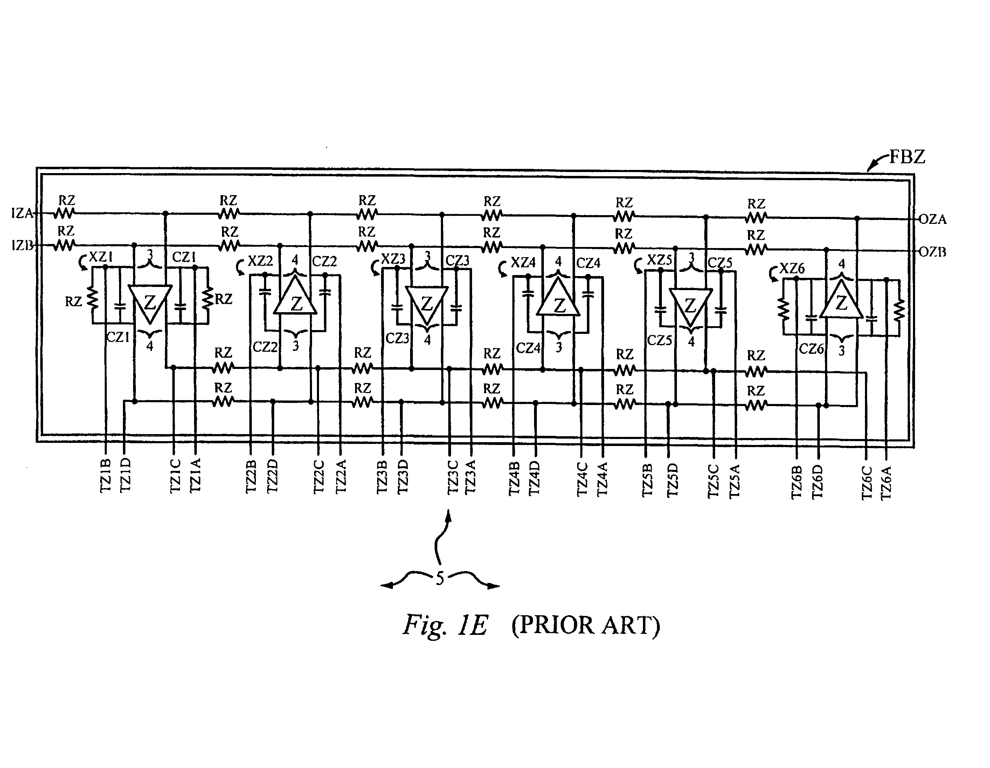

A second example of filter design is shown in Figures 1D and 1E. Figure 1D shows a low-pass sixth-order passive LC filter 6 with six nodes, NZ1, NZ2, NZ3, NZ4, NZ5, and NZ6, numbered sequentially clockwise from the top left. The input voltage Vzin is applied across NZ1 and NZ6. The output voltage Vzout is measured across NZ5 and NZ6. A first resistor RPZ1 is connected between NZ1 and NZ2. A first capacitor CPZ1 is connected between NZ2 and NZ6. A first inductor LPZ1 is connected between NZ2 and NZ3. A second capacitor CPZ2 is connected between NZ3 and NZ6. A second inductor LPZ2 is connected between NZ3 and NZ4. A third capacitor CPZ3 is connected between NZ4 and NZ6. A third inductor LPZ3 is connected between NZ4 and NZ5. A second resistor RPZ2 is connected between NZ5 and NZ6.

Figure 1E shows a low-pass sixth-order active-RC filter block (hereafter "FBZ") that approximates the transfer function of the low-pass sixth-order passive LC filter shown in Figure 1D. FBZ includes: two input terminals IZA and IZB; two output terminals OZA and OZB; six reactances XZ1, XZ2, XZ3, XZ4, XZ5, and XZ6; and twenty-six matched resistors RZ. Each reactance is an active balanced integrating circuit than includes: one balanced differential amplifier 2, a reactance input pair 3; a reactance output pair 4; and a matched capacitor pair CZ1, CZ2, CZ3, CZ4, CZ5, and CZ6. In each matched capacitor pair: one capacitor of each matched pair is shunted between the first input of a reactance input pair 3 and the first output of the reactance output pair 4; and the other capacitor is shunted between the second input of the reactance input pair 3 and the second output of the reactance output pair 4.

The internal nodes of FBZ can be identified by their associated terminal 5, as set forth in Table III below.

TABLE III:

| FBZ Nodes Identified by Terminal Number | | | |
|---|---|---|---|
| Reactance | First/Second | Input/Output | Terminal |
| XZ1 | second | input | TZ1A |
| XZ1 | first | input | TZ1B |
| XZ1 | second | output | TZ1C |
| XZ1 | first | output | TZ1D |
| XZ2 | second | output | TZ2A |
| XZ2 | first | output | TZ2B |
| XZ2 | first | input | TZ2C |
| XZ2 | second | input | TZ2D |
| XZ3 | second | input | TZ3A |
| XZ3 | first | input | TZ3B |
| XZ3 | first | output | TZ3C |
| XZ3 | second | output | TZ3D |
| XZ4 | second | output | TZ4A |
| XZ4 | first | output | TZ4B |
| XZ4 | first | input | TZ4C |
| XZ4 | second | input | TZ4D |
| XZ5 | second | input | TZ5A |
| XZ5 | first | input | TZ5B |
| XZ5 | second | output | TZ5C |
| XZ5 | first | output | TZ5D |
| XZ6 | second | output | TZ6A |
| XZ6 | first | output | TZ6B |

TABLE III:   (continued)

| FBZ Nodes Identified by Terminal Number | | | |
|---|---|---|---|
| Reactance | First/Second | Input/Output | Terminal |
| XZ6 | first | input | TZ6C |
| XZ6 | second | input | TZ6D |

Note also that the output terminal OZA is attached to TZ6A and that the output terminal OZB is attached to TZ6B. The Table IV netlist below indicates the location of the twenty-six matched resistors RZ. In the table, one matched resistor RZ is connected between the first node and the second node.

TABLE IV:

| Resistors Connected Within FBZ | |
|---|---|
| First Node | Second Node |
| IZA | TZ1A |
| IZB | TZ1B |
| TZ1A | TZ2A |
| TZ1B | TZ2B |
| TZ1C | TZ2C |
| TZ1D | TZ2D |
| TZ2A | TZ3A |
| TZ2B | TZ3B |
| TZ2C | TZ3C |
| TZ2D | TZ3D |
| TZ3A | TZ4A |
| TZ3B | TZ4B |
| TZ3C | TZ4C |
| TZ3D | TZ4D |
| TZ4A | TZ5A |
| TZ4B | TZ5B |
| TZ4C | TZ5C |
| TZ4D | TZ5D |
| TZ5A | TZ6A |
| TZ5B | TZ6B |
| TZ5C | TZ6C |
| TZ5D | TZ6D |
| TZ1A | TZ1C |
| TZ1B | TZ1D |
| TZ6A | TZ6D |
| TZ6B | TZ6C |

While resistors RZ are shunted across XZ1 and XZ6, no resistors RZ are shunted across XZ2, XZ3, XZ4, or XZ5.

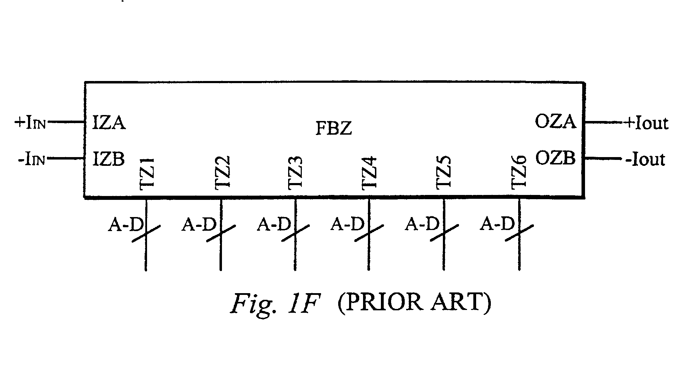

Figure 1F shows a block diagram of FBZ. The block diagram has two inputs IZA and IZB. The block diagram has two output terminals OZA and OZB. The block diagram also has six sets of four-lead terminals for a total of twenty-four terminals. The first set is labeled TZ1 and is composed of four terminals TZ1A, TZ1B, TZ1C, and TZ1D. The second set is labeled TZ2 and is composed of four terminals TZ2A, TZ2B, TZ2C, and TZ2D. The third set is labeled TZ3 and is composed of four terminals TZ3A, TZ3B, TZ3C, and TZ3D.

The fourth set is labeled TZ4 and is composed of four terminals TZ4A, TZ4B, TZ4C, and TZ4D. The fifth set is labeled TZ5 and is composed of four terminals TZ5A, TZSB, TZ5C, and TZ5D. The sixth set is labeled TZ6 and is composed of four terminals TZ6A, TZ6B, TZ6C, and TZ6D. Figure 1F also demonstrates how FBZ receives a 2-phase input +Iin and -Iin, by input terminals IZA and IZB respectively, to generate a 2-phase output signal +Iout and -Iout, through output terminals OZA and OZB respectively.

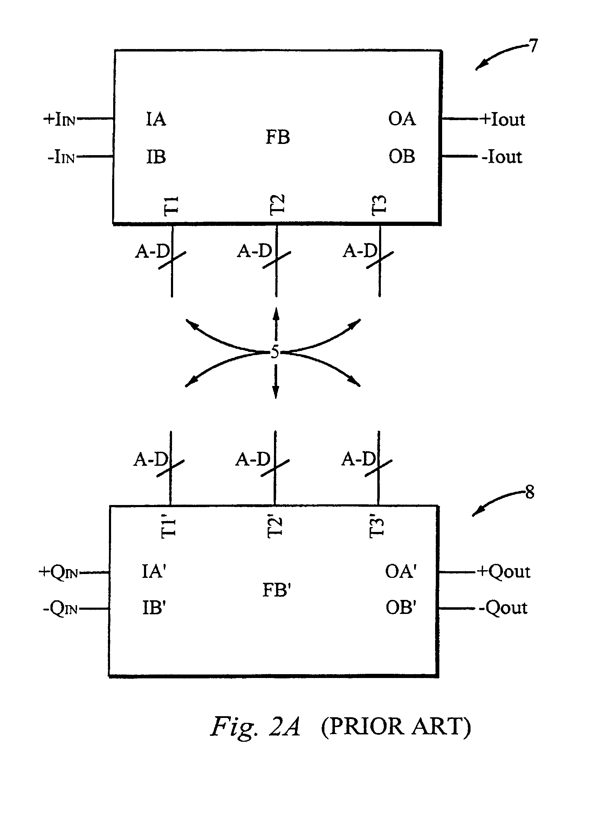

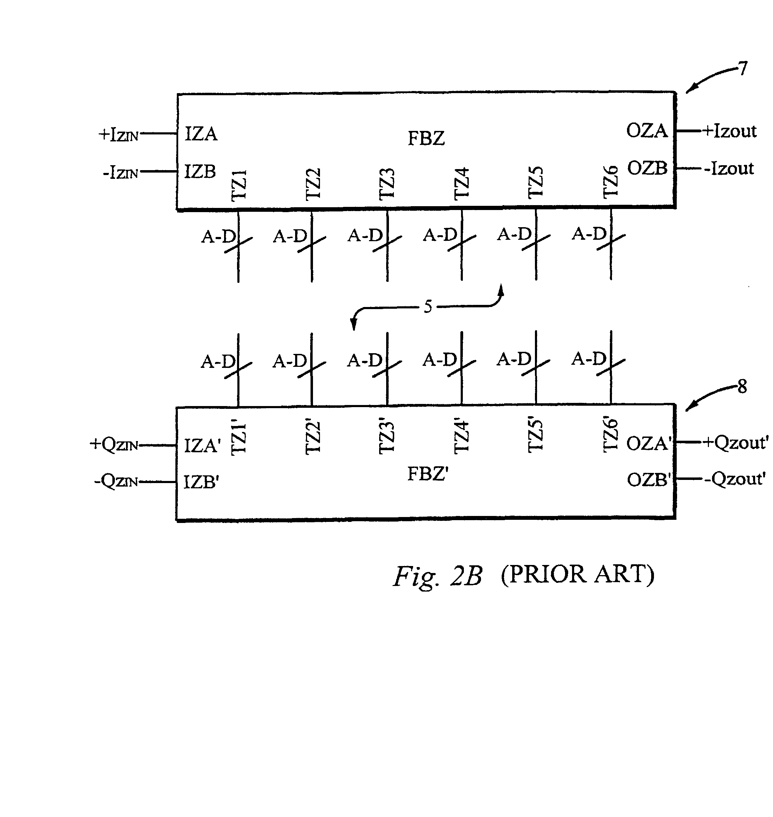

Figures 2A and 2B demonstrate how low-pass quadrature filters can be constructed from a first filter section 7 for the I signals and a second filter section 8 for the Q signals. Figure 2A shows a first filter section FB and a second filter section FB'. Both FB and FB' are identical to the third-order low-pass active RC filter illustrated in Figures 1B and 1C. The first filter section FB is attached to a 2-phase input +Iin and -Iin, by FB input terminals IA and IB respectively, to generate a 2-phase output +Iout and -Iout, through FB output terminals OA and OB respectively. The second filter section FB' is attached to a 2-phase input +Qin and -Qin, by FB' input terminals IA' and IB' respectively, to generate a 2-phase output +Qout and -Qout, through FB' output terminals OA' and OA' respectively. The terminals of FB and FB' are not used in this configuration.

Figure 2B shows a first filter section FBZ and a second filter section FBZ'. The first filter section FBZ and the second filter section FBZ' are both identical to the low-pass sixth-order active RC filter illustrated in Figures 1E and 1F. The first filter section FBZ is connected to inputs +Iin and -Iin by input terminals IZA and IZB, respectively, and to outputs +Izout and -Izout by ouput terminals OZA and OZB, respectively. The second filter section FBZ' is connected to inputs +Qin and -Qin by input terminals IZA' and IZB', respectively, and to outputs +Qzout and -Qzout by output terminals OZA' and OZB', respectively. The terminals of FBZ and FBZ' are not used in this configuration.

Though the circuit path for the I and Q signal inputs never intersect each other in the circuits shown in Figure 2A and 2B, the two filter sections perform as a low-pass sixth-order quadrature filter and low-pass twelfth-order quadrature filter, respectively. Since the bandpass of the quadrature filter includes both low positive frequencies and low negative frequencies, the quadrature filters shown in Figures 2A and 2B act like band-pass filters with a center frequency of zero hertz.

The Voorman Patent (U.S. Pat. No. 4,914,408) discloses that a quadrature band-pass filter can be created by cross-coupling the reactances of two filter sections with matched resistors. Application of this approach can be accomplished by shunting matched resistors between the terminals 5 of the first filter section FBZ and the terminals 5 of the second filter section FBZ'.

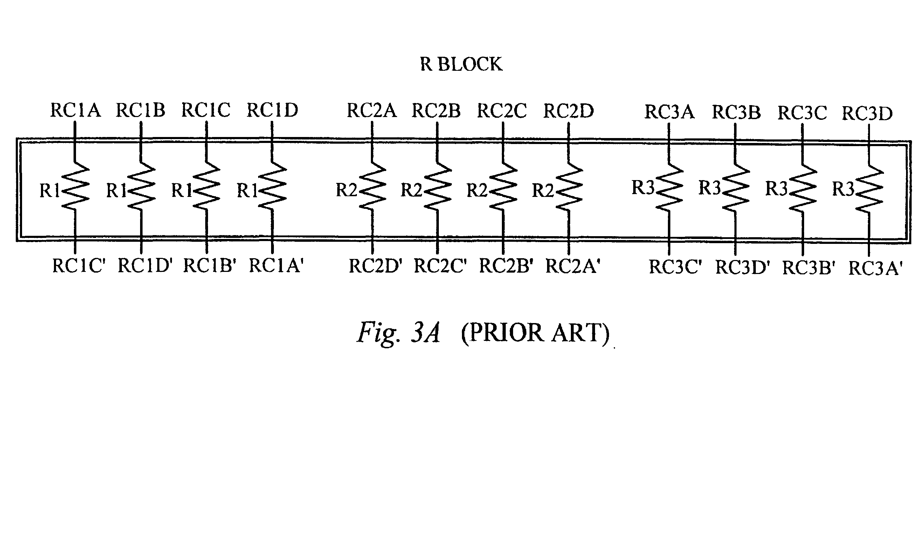

To simplify representation of the matched resistors, Figures 3A to 3D describe two resistor coupling blocks and their contents. Figure 3A shows three sets of four matched resistors, R1, R2 and R3. Each resistor has a node on either end. The node netlist for each resistor is set forth in Table V below.

TABLE V:

| Resistors Connected Between First Node and Second Node | | |
|---|---|---|
| First Node | Second Node | Matched Resistor |
| RC1A | RC1C' | R1 |
| RC1B | RC1D' | R1 |
| RC1C | RC1B' | R1 |
| RC1D | RC1A' | R1 |
| RC2A | RC1D' | R2 |
| RC2B | RC1C' | R2 |
| RC2C | RC1B' | R2 |
| RC2D | RC1A' | R2 |
| RC3A | RC1C' | R3 |
| RC3B | RC1D' | R3 |
| RC3C | RC1B' | R3 |
| RC3D | RC1A' | R3 |

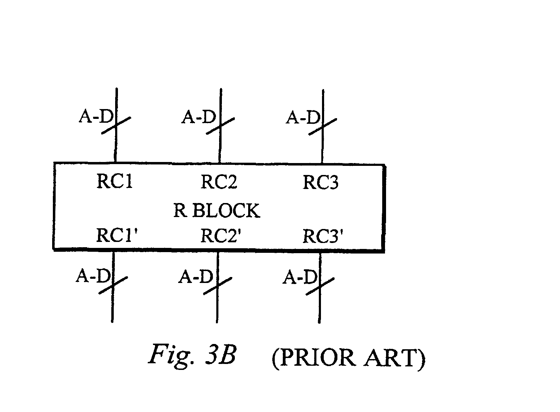

Figure 3B shows the resistor coupling block diagram labeled "R block." The R block has 24 leads. The leads are grouped into sets of four leads labeled RC1, RC2, RC3, RC1', RC2', and RC3'. Each set has an A, B, C, and D lead. RC1, for instance, has leads RC1A, RC1B, RC1C, and RC1D. And RC1' has leads RC1A', RC1B', RC1C', and RC1D'.

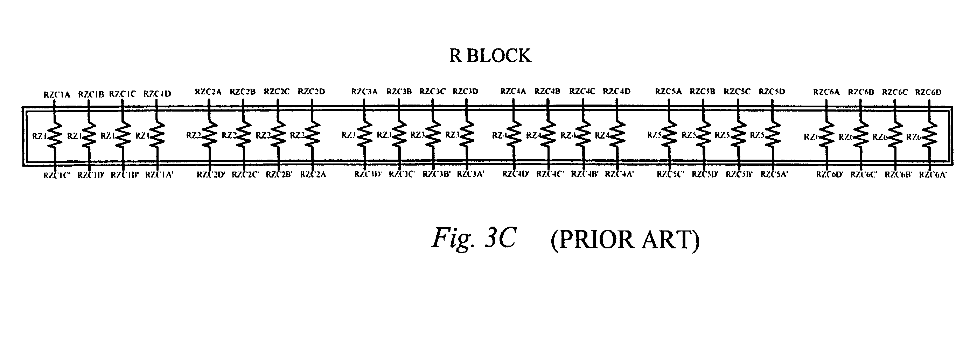

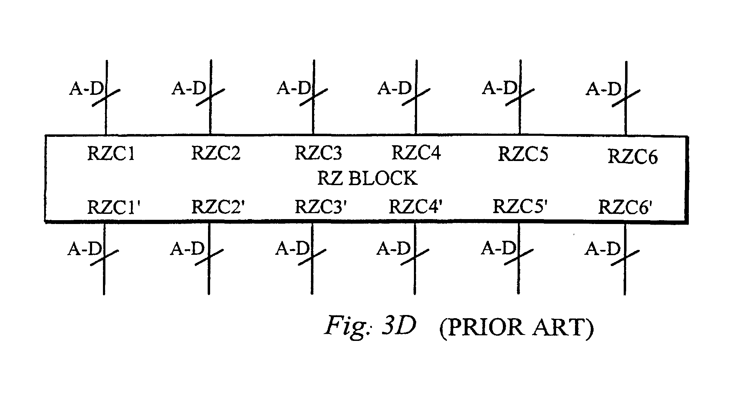

Figures 3C and 3D describe the resistor block for FBZ. Figure 3B shows six sets of four matched resistors, RZ1, RZ2, RZ3, RZ4, RZ5, and RZ6. Each resistor has a node on either end. The node netlist for each resistor is set forth in Table VI below.

TABLE VI:

| Resistors Connected Between First Node and Second Node | | |
|---|---|---|
| First Node | Second Node | Matched Resistor |
| RZC1A | RZC1C' | RZ1 |
| RZC1B | RZC1D' | RZ1 |
| RZC1C | RZC1B' | RZ1 |
| RZC1D | RZC1A' | RZ1 |
| RZC2A | RZC2D' | RZ2 |
| RZC2B | RZC2C' | RZ2 |
| RZC2C | RZC2B' | RZ2 |
| RZC2D | RZC2A' | RZ2 |
| RZC3A | RZC3D' | RZ3 |
| RZC3B | RZC3C' | RZ3 |
| RZC3C | RZC3B' | RZ3 |
| RZC3D | RZC3A' | RZ3 |
| RZC4A | RZC4D' | RZ4 |
| RZC4B | RZC4C' | RZ4 |
| RZC4C | RZC4B' | RZ4 |
| RZC4D | RZC4A' | RZ4 |
| RZC5A | RZC5C' | RZ5 |
| RZC5B | RZC5D' | RZ5 |
| RZC5C | RZC5B' | RZ5 |
| RZC5D | RZC5A' | RZ5 |
| RZC6A | RZC6D' | RZ6 |
| RZC6B | RZC6C' | RZ6 |
| RZC6C | RZC6B' | RZ6 |
| RZC6D | RZC6A' | RZ6 |

Figure 3D shows the resistor coupling block diagram labeled "RZ block." The RZ block has forty-eight leads. The leads are grouped into sets of four leads labeled RZC1, RZC2, RZC3, RZC4, RZC5, RZC6, RZC1', RZC2', RZC3', RZC4', RZC5', and RZC6'. Each set has an A, B, C, and D lead.

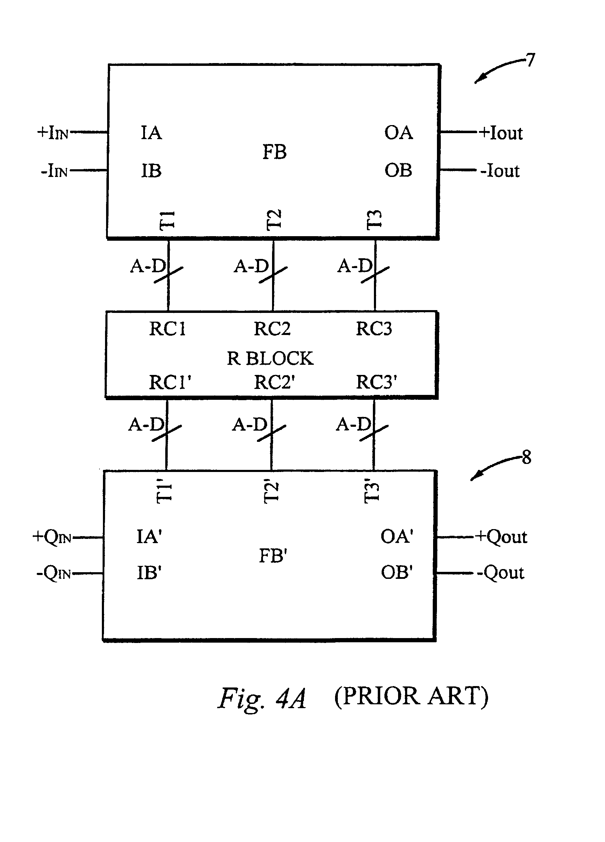

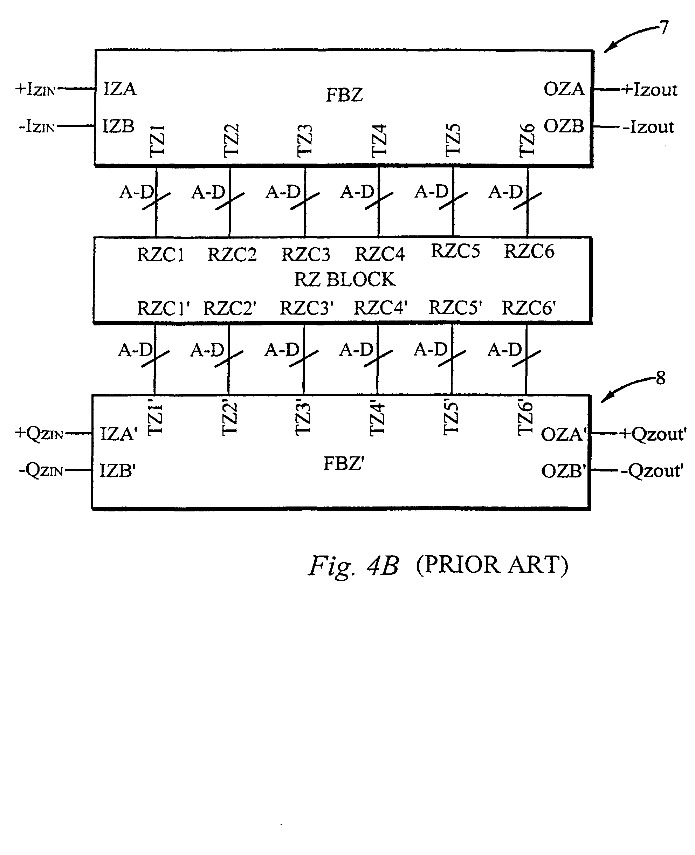

Figures 4A shows a first filter section FB and a second filter section FB' coupled together through an R block. Excluding the addition and coupling of the R block, Figure 4A shows the same quadrature filter configuration as in Figure 2A. Corresponding R block leads are connected to the terminals of the first filter section FB and the section filter section FB'. RC1A and RC1A', for instance, are connected to T1A and T1A' respectively. The coupling of the first filter section FB to the second filter section FB' in Figure 4B follows the same method as Figure 4A, except that the RZ block is used to couple FBZ and FBZ'.

Coupling the filter sections of a low-pass quadrature filter changes the quadrature filter in two ways. First, the coupling reduces the quadrature filter's sensitivity to component variations between the first filter section FBZ and the second filter section FBZ'. As the I and Q signals share many components, component variations effects have approximately the same impact upon each signal's transfer function. A second result of the cross-coupling is that the center frequency of the quadrature filter is moved from zero hertz to a new center frequency. As disclosed in the Voorman Patent, the center frequency of the coupled filter is equal to $1 / R_i C_i$, where $R_i$ is the value of an individual cross-coupling resistor between two corresponding reactances and $C_i$ is the capacitance of an single matched capacitor shunted between the input and output of the corresponding reactances. During design of integrated circuits containing these active quadrature band-pass filters, the center frequency can be adjusted by adjusting the value of $R_i$ and $C_i$.

The resistor cross-coupling disclosed in the Voorman Patent has some limitations. First, the center frequency cannot be altered post-manufacture, as resistors and capacitors are passive elements with non-adjustable values. Second, component variations between the first filter section and the second filter section can degrade output signal quality. The resistors are shunted across operational amplifiers, which are susceptible to variation in common mode voltage or DC offset voltage. A mismatch between corresponding operational amplifiers can result in larger than expected or smaller than expected currents through a coupling resistor. Larger than expected and smaller than expected currents can also result from component variations between matched capacitor and resistors.

SUMMARY OF THE INVENTION:

The invention is an improved implementation of an active-RC polyphase band-pass filter with transconductor cross-coupling between filter sections. The polyphase filter has first to fourth inputs, first to fourth outputs, two filter sections, and a block of transconductor pairs. The four input signals to the polyphase filter succeed one another in phase by 90 degrees. The two filter sections have reactances comprised of active balanced operational amplifiers with matched capacitors in their feedback loops. Each transconductor pair of the block is coupled between corresponding reactances of each filter. The transconductance value of each transconductor pair is set as the product of a desired radian center frequency and the capacitance of the corresponding matched capacitors. In the preferred embodiment, the transconductors are Gm cells and the transconductance value of at least one Gm cell is field adjustable. This means that the transconductance value can be adjusted after the filter has been constructed or placed in service. The filter sections of the preferred embodiment can be a pair of low-pass, third-order, active-RC gaussian filters or a pair of low-pass sixth-order active-RC gaussian filters.

The first filter section has X-reactances and M-terminals. The second filter section has Y-reactances and N-terminals. The filter sections are coupled by the block of transconductors with a total of M plus N terminals. The X-reactances are coupled to the first input, the third input, the first output, and the third output. The Y-reactances are coupled to the second input, the fourth input, the second output, and the fourth output of the output. The M-terminals are coupled to select ones of the X-reactances. The N-terminals are coupled to select ones of the Y-reactances. In the preferred embodiment: X and Y are equal and M and N are equal; one half of the M-terminals are coupled to reactance input terminal pairs of the first filter section and the other half are coupled to reactance output terminal pairs of the first filter section; and one half of the N-terminals are coupled to reactance input terminal pairs of the second filter section and the other half are coupled to reactance output terminal pairs of the second filter section.

The reactances of each filter section are comprised of active balanced integrating circuits. Each active balance integrating circuit has a balanced differential operational amplifier with matched capacitors in their feedback loop. The balanced differential operational amplifier has a reactance input terminal pair and a reactance output terminal pair. The first matched capacitor is shunted between the first input of the reactance input terminal pair and the first output of the reactance output terminal pair. The second matched capacitor is shunted between the second input terminal of the reactance input terminal pair and the second output of the reactance output terminal pair. The matched capacitors of the first to Xth reactance and the corresponding matched capacitors of the first to Yth reactance are of equal capacitance.

The block of transconductors is composed of Z-transconductor pairs composed of Gm cells. Each of the Z-transconductor pairs cross-couple a reactance of the first filter section through its M-terminals and the correspoding reactances of the second filter section through its N-terminals. Each Gm cell has one transconductor input terminal pair and one transconductor output terminal pair. The transconductance value of each Gm cell is set as the product of a desired radian center frequency and the capacitance of the nearest matched capacitors. In the preferred embodiment, the transconductance value of at least one Gm cell is field adjustable, permitting adjustment of the center frequency in the field.

In each Z-transconductor pair, one Gm cell is coupled by its transconductor input terminal pair to a reactance output terminal pair of a corresponding X-reactance through a selected pair of M-terminals and by its transconductor output terminal pair to a reactance input terminal pair of a corresponding Y-reactance through a selected pair of N-terminals. The second Gm cell in each Z-transconductor pair is coupled by its transconductor input terminal pair to a reactance output terminal pair of a corresponding Y-reactance through a selected pair of N-terminals and by its transconductor output terminal pair to a reactance input terminal pair of a corresponding X-reactance through a selected pair of M-terminals. As the inputs of each Gm cell are a differential voltage from a single reactance, variation in the common mode voltage or DC offset between the filter sections does not adversely affect the polyphase filter's transfer function.

BRIEF DESCRIPTION OF THE DRAWINGS:

Figure 1A is a schematic of a low-pass third-order passive LC filter;
Figure 1B is a schematic of an active-RC filter design of the low-pass third-order passive LC filter shown in Figure 1A;
Figure 1C is a block diagram of the low-pass third-order active-RC filter shown in Figure 1B;
Figure 1D is a schematic of a low-pass sixth-order passive LC filter;
Figure 1E is a schematic of an active-RC filter design of the low-pass sixth-order passive LC filter shown in Figure 1D;
Figure 1F is a block diagram of the low-pass sixth-order active-RC filter shown in Figure 1E;
Figure 2A illustrates a low-pass third-order quadrature filter constructed from two of the low-pass third-order active-RC filter blocks shown in Figure 1C;
Figure 2B illustrates a low-pass sixth-order quadrature filter constructed from two of the low-pass sixth-order active-RC filter blocks shown in Figure 1F;
Figure 3A shows the nodal connections for the R block;
Figure 3B shows the block diagram of the R block;
Figure 3C shows the nodal connections for the RZ block;
Figure 3D shows the block diagram of the RZ block;
Figure 4A shows a band-pass sixth-order quadrature filter constructed from two low-pass third-order active-RC filters coupled together by one R block;
Figure 4B shows a band-pass twelfth-order quadrature filter constructed from two low-pass sixth-order active-RC filters coupled together by one RZ block;
Figure 5A is a schematic of a reactance from the first filter section, a reactance from the second filter section, a transconductor pair, and a set of resistors;
Figure 5B is a schematic of a transconductor pair used in the coupling of FB pairs;
Figure 5C is a schematic of a G block used in the coupling of FB pairs;
Figure 5D is a block diagram of the G block shown in Figure 5C;
Figure 5E is a schematic of a transconductor pair used in the coupling of FBZ pairs;
Figure 5F is a schematic of a GZ block used in the coupling of FBZ pairs;
Figure 5G is a block diagram of the GZ block shown in Figure 5F;
Figure 6A shows a band-pass sixth-order quadrature filter constructed from two low-pass third-order active-RC filters coupled together by one G block;
Figure 6B shows a band-pass twelfth-order quadrature filter constructed from two low-pass sixth-order active-RC filters coupled together by one GZ block.

DETAILED DESCRIPTION OF THE PREFERRED EMBODIMENT:

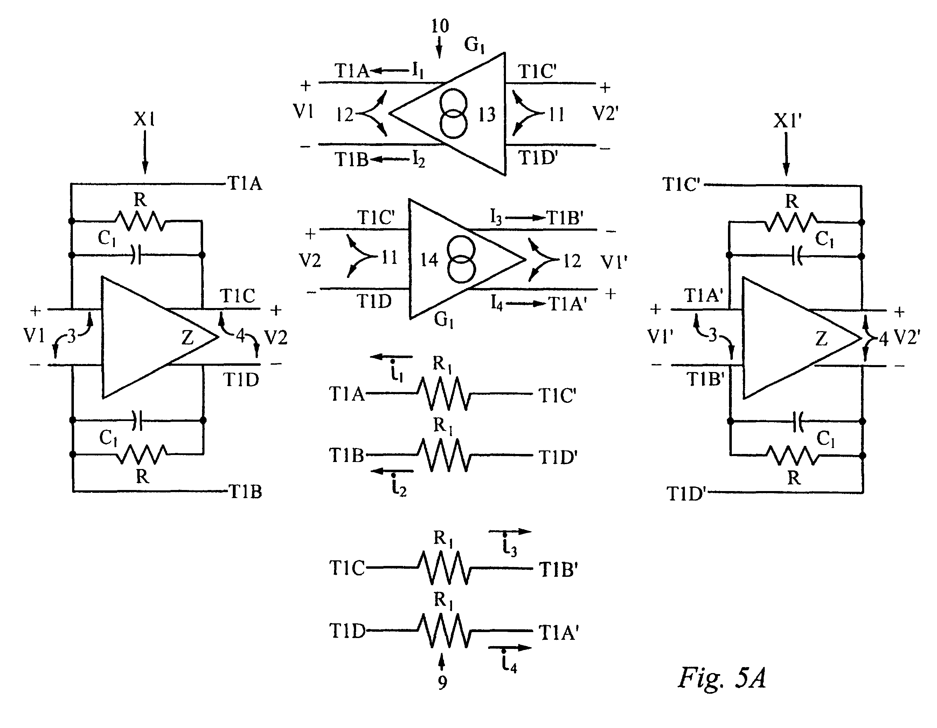

The invention cross-couples a first 2-phase filter section and a second 2-phase filter section with transconductors to create a band-pass quadrature filter. This implementation reduces the filter's sensitivity to component variations and permits the center frequency of the filter to be field adjusted.
In the preferred embodiment of the present invention there is an interaction of paired reactances between the first filter section FB and the second filter section FB1. Figure 5A shows four items: the first reactance of the first filter section, X1; the first reactance of the second filter section, X1'; the nodal connections between the matched resistors 9 and the two filter sections; and the nodal connections between the transconductors 10 and the two filter sections. Each reactance X1, X1' includes a balanced differential operational amplifier 2, a reactance input pair 3, a reactance output pair 4, and a feedback path between the output pairs and the input pairs. The feedback path consists of a resistor R and a matched capacitor C1 in parallel. The nodal connection information for the matched resistors 9 can be identified by their associated terminal 5 and by the node netlist. The nodal connection information for the transconductors is derived below. A view of X1 in the context of FB can be seen in Figure 1B.
The transconductors each have a transconductor input terminal pair 11 and a transconductor output terminal pair 12. The first transconductor 13 receives its input signals from the reactance output pair of X1' and the second transconductor 14 receives its input signals from the reactance output pair of X1. The first transconductor 13 has two output currents, I1 and I2, and the second transconductor 14 has two output currents, I3 and I4. In the first transconductor 13, the voltage across the transconductor output terminal pair 12 is V1 and the voltage across the transconductor input terminal pair 11 is V2'. In the second transconductor 14, the voltage across the transconductor output pair 12 is V1' and the voltage across the transconductor input terminal pair 11 is V2. The transconductance of both transconductors is G1.

The transconductors 13, 14 shown in Figure 5A, are operational transconductor amplifiers, also known as Gm cells. It is well known that Gm cells convert a differential voltage into proportional differential current. As used in the invention, the Gm cells create equivalent currents between the first filter section 7 and the second filter section 8. In Figure 5A, the currents of the replaced resistors R1 are labeled i1, i2, i3, and i4. For the transconductors, 13 and 14, to properly replace the resistors R1: I1 should be equal to i1; I2 should be equal to i2; I3 should be equal to i3; and I4 should be equal to i4. The below Equation 1 and Equation 2 are derived from Ohm's Law. Equation 1 and Equation 2 state the differential current across the matched resistors 9. V1 and V1' are not variables in Equation 1 and Equation 2 because the feedback loop across each operational amplifier 2 drives V1 and V1' to a much smaller voltage than V2 and V2'.

$$i1 - i2 = V2'/R1 \qquad\qquad \text{Equation 1}$$

$$i3 - i4 = V2/R1 \qquad\qquad \text{Equation 2}$$

Gm cells operate according to the below equations, where Vd is the differential input voltage, G is the transconductance, and +Ig and -Ig are the differential output currents.

$$+Ig = (Vd \times G)/2 \qquad\qquad \text{Equation 3}$$

$$-Ig = -(Vd \times G)/2 \qquad\qquad \text{Equation 4}$$

Applying these equations to the Figure 5A circuit elements we obtain:

$$I1 - I2 = V2' \times G1 \qquad\qquad \text{Equation 5}$$

$$I3 - I4 = V2 \times G1 \qquad\qquad \text{Equation 6}$$

If G1 is set equal to 1 / R1, Equation 5 and Equation 6 become:

$$I1 - I2 = V2'/R1 \qquad\qquad \text{Equation 7}$$

$$I3 - I4 = V2/R1 \qquad\qquad \text{Equation 8}$$

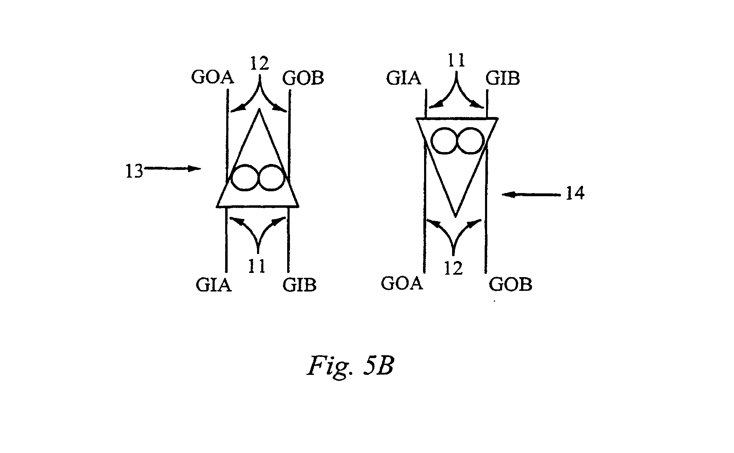

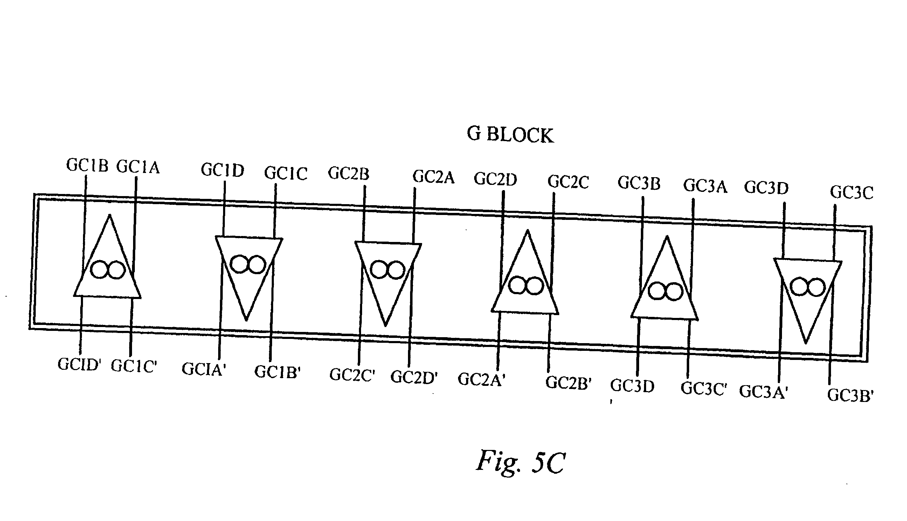

To simplify representation of the Gm cells 13, 14, Figures 5B to 5D describe a Gm coupling block and its contents for a sixth-order band-pass quadrature filter. Figure 5B shows a transconductor pair including a first transconductor 13 and a second transconductor 14. Each Gm cell has a transconductor input terminal pair 11, including input leads GIA and GIB, and a transconductor output terminal pair 12, including output leads GOA and GOB. Figure 5C shows three sets of matched transconductor pairs 13, 14 with transconductance G1, G2, and G3. The node netlist for each Gm cell in Fig. 5C is set forth in Table VII below.

TABLE VII:

| Gm Cell Connections | | | | |
|---|---|---|---|---|
| GIA | GIB | GOA | GOB | Matched Gm Cell |
| GC1D' | GC1C' | GC1B | GC1A | first G1 |
| GC1D | GC1C | GC1A' | GC1B' | second G1 |
| GC2B | GC2A | GC2C' | GC2D' | first G2 |
| GC2A' | GC2B' | GC2D | GC2C | second G2 |
| GC3D' | GC3C' | GC3B | GC2A | first G3 |
| GC3D | GC3C | GC3A' | GC3B' | second G3 |

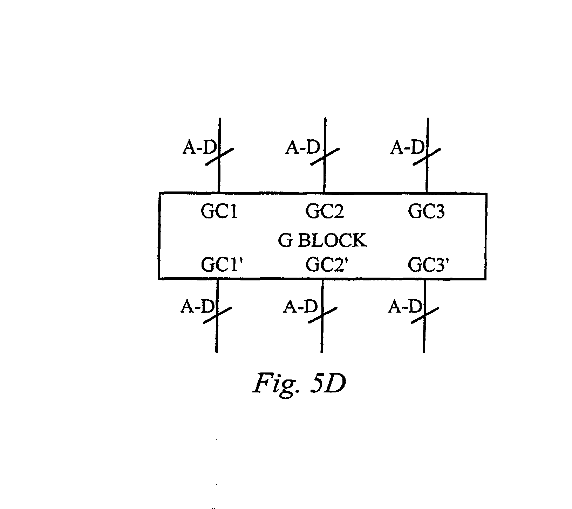

Figure 5D shows a transconductance coupling block diagram labeled "G block." The G block has twenty-four leads. The leads are grouped into sets of four leads labeled GC1, GC2, GC3, GC1', GC2', and GC3'. Each set has an A, B, C, and D lead. GC1, for instance, has leads GC1A, GC1B, GC1C, and GC1D. And GC1' has leads GC1A', GC1B', GC1C', and GC1D'.

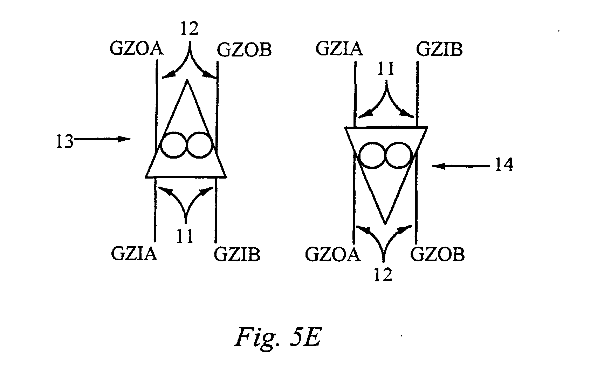

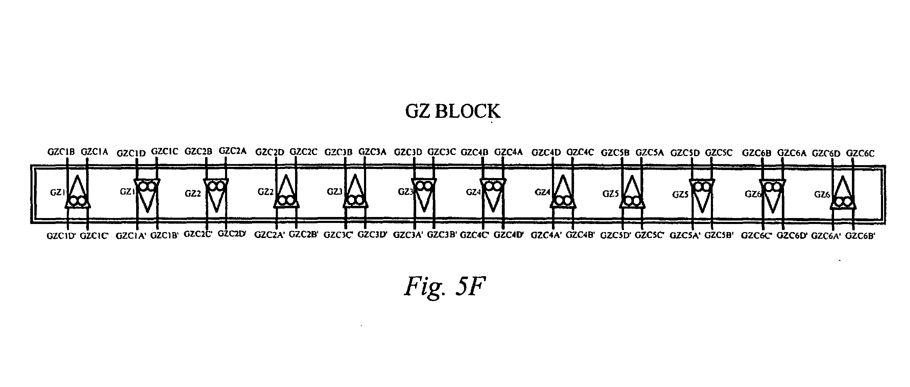

Figures 5E to 5G describe a Gm coupling block and its contents for the sixth-order band-pass quadrature filter. Figure 5E shows a transconductor pair with a first transconductor 13 and a second transconductor 14. Each Gm cell has a transconductor input pair 11, with input leads labeled GZIA and GZIB, and a transconductor output pair 12, with output leads labeled GZOA and GZOB. Figure 5F shows six sets of matched transconductor pairs with transconductance GZ1, GZ2. GZ3, GZ4, GZ5, and GZ6. The node netlist for each Gm cell is set forth in Table VIII below.

TABLE VIII:

| Gm Cell Connections | | | | |
|---|---|---|---|---|
| GZIA | GZIB | GZOA | GZOB | Matched Gm Cell |
| GZC1D' | GZC1C' | GZC1B | GZC1A | first GZ1 |
| GZC1D | GZC1C | GZC1A' | GZC1B' | second GZ1 |
| GZC2B | GZC2A | GZC2C' | GZC2D' | first GZ2 |
| GZC2A' | GZC2B' | GZC2D | GZC2C | second GZ2 |
| GZC3C' | GZC3D' | GZC3B | GZC3A | first GZ3 |
| GZC3D | GZC3C | GZC3A' | GZC3B' | second GZ3 |
| GZC4B | GZC4A | GZC4C' | GZC4D' | first GZ4 |
| GZC4A' | GZC4B' | GZC4D | GZC4C | second GZ4 |
| GZC5D' | GZC5C' | GZC5B | GZC5A | first GZ5 |
| GZC5D | GZC5C | GZC5A' | GZC5B' | second GZ5 |
| GZC6B | GZC6A | GZC6C' | GZC6D' | first GZ6 |
| GZC6A' | GZC6B' | GZC6D | GZC6C | second GZ6 |

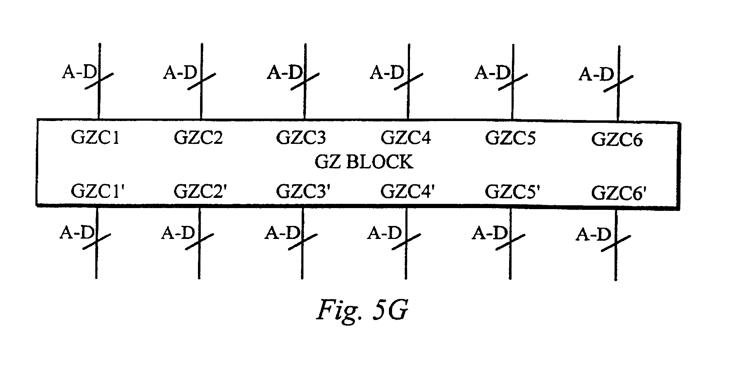

Figure 5G shows the transconductance coupling block diagram labeled "GZ block." The GZ block has forty-eight leads. The leads are grouped into sets of four leads labeled GZC1, GZC2, GZC3, GZC4, GZC5, GZC6, GZC1', GZC2', GZC3', GZC4', GZC5', and GZC6'. Each set has an A, B, C, and D lead.

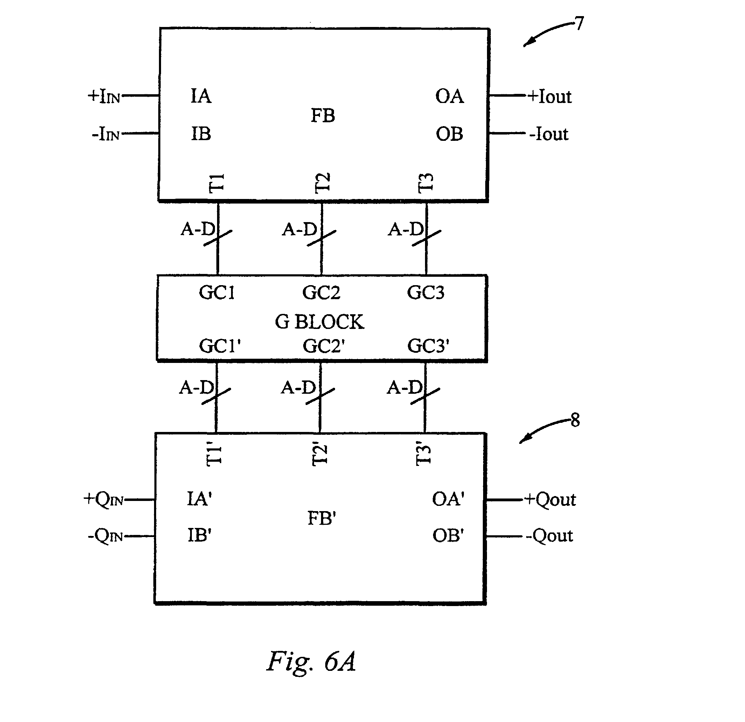

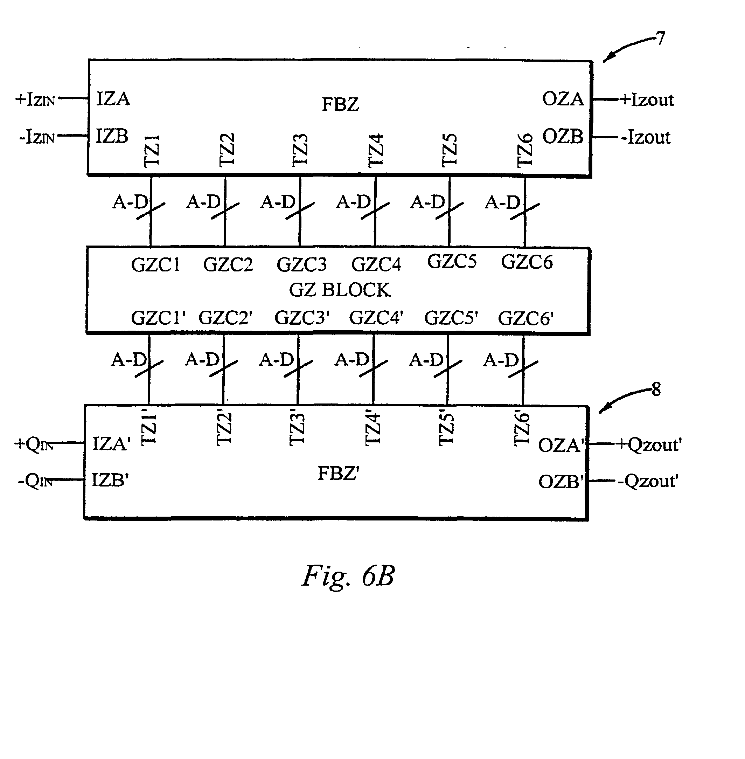

Figures 6A shows a first filter section 7 and a second filter section 8 coupled together through an G block. Excluding the addition and coupling of the G block. Figure 6A shows the same quadrature filter configuration as in Figure 2A. Corresponding G block leads are connected to the terminals of the first filter section 7 and the second filter section 8. GC1A and GC1A', for instance, are connected to T1A and T1A' respectively. The coupling of the first filter section 7 to the second filter section 8 in Figure 6B follows the same method as Figure 6A, except that the GZ block is used to couple FBZ and FBZ'.

The present invention has the advantage of reducing imbalances between filter section from common mode voltage and DC offset of each filter section's operational amplifier 2 outputs. In contrast, in the prior art arrangement of Figs. 1-4, differences in the common mode voltage or DC offset of pair reactances can result in currents across the cross coupling resistors that are larger or smaller than expected. As current magnitudes stray from the desired theoretical values, the transfer function of the active-RC filter can be altered unpredictably. As used in the present invention, Gm cells are unaffected by mismatched common mode voltages and mismatched DC offsets. Unlike the prior art arrangement, the Gm cell current is not based upon the voltage potential between a first filter section 7 node and a second filter section 8 node. The output current of a Gm cells is based upon the differential input from the output pair of one balanced operational amplifier of one filter section. The common mode and DC offset voltages, therefore, are subtracted out.

The present invention also permits the center frequency of the quadrature filter to be field adjustable. Unlike an integrated resistor or capacitor, the conductance value of the Gm cells can be easily adjusted in the field by electronic means. The center frequency of the quadrature filter is equal to the transconductance value of a matched pair divided by its associated capacitance value. By altering the transconductance value electronically, the center frequency of the quadrature filter can be moved at will to a selected frequency. A field adjustable center frequency means that components can be tuned after manufacturing or being placed in service. A field adjustable architecture also allows the manufacturer to make one part for applications requiring different center frequencies or for applications requiring center frequencies adjustable during operation of the end-user device.

Using the present invention, it is possible to individually transform each reactance in a filter. The transformation can take place by scaling each resistance associated with a reactance in a filter by a scaling factor and by likewise scaling each capacitance and the associated Gm by the inverse of the scaling factor. Using such a transformation maintains the reactance. The transformation can be performed to optimize the signal handling capability of the filter. The transformation can also be performed to allow the selection of more convenient values for resistors and capacitors. Considering Figure 5A, the reactance labeled X1 can be transformed by scaling its resistors R and the associated resistors R1 by a scaling factor. The capacitors C1 for this reactance are scaled by the inverse of the scaling factor. Also the Gm of the transconductor 13 is scaled by the inverse of the scaling factor.

The present invention has been described in terms of specific embodiments incorporating details to facilitate the understanding of principles of construction and operation of the invention. Specifically, it will be apparent to those skilled in the art that while the preferred embodiment of the present invention is used with third-order and sixth-order low-pass gaussian 2-phase filter sections, the present invention could also be implemented on other types of filters, filters sections of different orders, or filters section of more than two phases.

**Claims**

1. An active polyphase filter with transconductor cross-coupling of filter sections, comprising:

　　a. first to fourth inputs (IIN, QIN) for applying a 4-phase input signal comprising first to fourth signal vectors, respectively, which succeed one another inphase by 90 degrees;
　　b. first to fourth outputs (IOUT, QOUT);
　　c. a first filter section comprising:

　　　　i) a number of X reactances wherein:

　　　　　　(1) each of the X reactances are active balanced integrating circuits (2) having one reactance input pair (3) and one reactance output pair (4); and
　　　　　　(2) each of the X reactances are coupled to the first input, the third input, the first output, and the third output; and

　　　　ii) a number of M terminals selectively coupled to reactance input pairs of the first filter section and reactance output pairs of the first filter section;

　　d. a second filter section (FB1) comprising:

　　　　i) a number of Y reactances wherein:

　　　　　　(1) each of the Y reactances are active balanced integrating circuits having one reactance input pair and one reactance output pair; and
　　　　　　(2) each of the Y reactances are coupled to the second input, the fourth input, the second output, and the fourth output; and

ii) a number of N terminals selectively coupled to reactance input pairs of the second filter section and reactance output pairs of the second filter section; and

e. a number of Z transconductor pairs cross-coupling the reactances of the first filter section through the M terminals and the reactances of the second filter section through the N terminals.

2. The active polyphase filter with transconductor cross-coupling of filter sections according to Claim 1, wherein:

   a. of the M-terminals:

   i) one half of the M-terminals are coupled to reactance input pairs of the first filter section; and
   ii) the other half of the M-terminals are coupled to reactance output pairs of the first filter section;

   b. of the N-terminals:

   i) one half of the N-terminals are coupled to reactance input pairs of the second filter section; and
   ii) the other half of the N-terminals are coupled to reactance output pairs of the second filter section; and

   c. of the Z-transconductor pairs:

   i) each of the transconductors have one transconductor input pair and one transconductor output pair; and
   ii) in each Z-transconductor pair:

      (1) one transconductor is coupled by its:

         (a) transconductor input pair to a reactance output pair of a corresponding X-reactance through a selected pair of M-terminals; and
         (b) transconductor output pair to a reactance input pair of a corresponding Y-reactance through a selected pair of N-terminals; and

      (2) the other transconductor is coupled by its:

         (a) transconductor input pair to a reactance output pair of a corresponding Y-reactance through a selected pair of N-terminals; and
         (b) transconductor output pair to a reactance input pair of a corresponding X-reactance through a selected pair of M-terminals.

3. The active polyphase filter with transconductor cross-coupling of filter sections according to Claim 1, wherein the transconductors are active balanced Gm cells.

4. The active polyphase filter with transconductor cross-coupling of filter sections according to Claim 1, wherein the transconductance of at least one transconductor is filed adjustable.

5. The active polyphase filter with transconductor cross-coupling of filter sections according to Claim 1, wherein:

   a. the first filter section and the second filter section are both third-order low-pass two-phase gaussian filters; and
   b. the value of:

      i) X and Y are equal;
      ii) M and N are equal: and
      iii) M is equal to four times the value of X.

6. The active polyphase filter with transconductor cross-coupling of filter sections according to Claim 1, wherein:

   a. the first filter section and the second filter section are both sixth-order low-pass two-phase gaussian filters; and
   b. the value of:

i) X, Y and Z are equal;
ii) M and N are equal; and
iii) M is equal to four times the value of X.

7. The active polyphase filter with transconductor cross-coupling of filter sections according to Claim 1, wherein:

a. the active balanced integrating circuits are comprised of:

i) a balanced differential amplifier coupled between the reactance input pair and the reactance output pair; and
ii) a matched capacitor pair, wherein:

(1) one matched capacitor is shunted between:

(a) the first input of the reactance input pair; and
(b) the first output of the reactance output pair; and

(2) the other matched capacitor is shunted between:

(a) the second input of the reactance input pair; and
(b) the second output of the reactance output pair;

b. the matched capacitors of the first to Xth reactance and the corresponding matched capacitors of the first to Yth reactance are of equal capacitance: and
c. the transconductance of each transconductor pair is set as the product of:

i) a desired radian center frequency; and
ii) the capacitance of the nearest matched capacitors coupled to the transconductor pair.

8. An active filter comprising:

a. a first filter section having a first plurality of reactances;
b. a second filter section having a second plurality of reactances wherein the first and second plurality of reactances include equal numbers;
c. a plurality of pairs of transconductors, each pair corresponding to one of the first plurality of reactances and to one of the second plurality of reactances, a first transconductor of each pair having a pair of inputs coupled to the corresponding one of the first plurality of reactances and a pair of outputs coupled to the corresponding one of the second plurality of reactances and a second transconductor of each pair having a pair of inputs coupled to the corresponding one of the second plurality of reactances and a pair of outputs coupled to the corresponding one of the first plurality of reactances.

9. The active filter according to Claim 8 wherein each transconductor is a balanced Gm cell.

10. The active filter according to Claim 8 wherein each reactance of the first and second plurality of reactances includes a differential amplifier having capacitive feedback.

11. The active filter according to Claim 8 wherein each reactance of the first and second plurality of reactances includes a balanced integrator.

12. The active filter according to Claim 8 wherein the active filter is a quadrature polyphase filter.

13. The active filter according to Claim 8 wherein the active filter is a third order filter.

14. The active filter according to Claim 8 wherein the active filter is a sixth order filter.

**Patentansprüche**

1. Aktives Polyphasenfilter mit Transkonduktorkreuzkopplung von Filtersektionen, das aufweist:

   a. erste bis vierte Eingänge (Iein, Qein) zum Anlegen eines 4-Phasen-Eingangssignals, das jeweils erste bis vierte Signalvektoren ausweist, die in Phasen von 90 Grad aufeinander folgen;
   b. erste bis vierte Ausgänge (Iaus, Qaus)
   c. eine erste Filtersektion (FB), die aufweist:

      i) eine Anzahl von X Reaktanzen, wobei

         (1) jede der X Reaktanzen aktive symmetrische Integrierglieder (2) mit einem Reaktanz-Eingangspaar (3) und einem Reaktanz-Ausgangspaar (4) sind; und
         (2) jede der X Reaktanzen mit dem ersten Eingang, dem dritten Eingang, dem ersten Ausgang und dem dritten Ausgang gekoppelt ist; und

      ii) eine Anzahl von M Anschlüssen, die selektiv mit Reaktanz-Eingangspaaren der ersten Filtersektion und Reaktanz-Ausgangspaaren der ersten Filtersektion gekoppelt sind;

   d. eine zweite Filtersektion (FB1), die aufweist:

      i) eine Anzahl von Y Reaktanzen, wobei

         (1) jede der Y Reaktanzen aktive symmetrische Integrierglieder mit einem Reaktanz-Eingangspaar und einem Reaktanz-Ausgangspaar sind; und
         (2) jede der Y Reaktanzen mit dem zweiten Eingang, dem vierten Eingang, dem zweiten Ausgang und dem vierten Ausgang gekoppelt ist; und

      (ii) eine Anzahl von N Anschlüssen, die selektiv mit Reaktanz-Eingangspaaren der zweiten Filtersektion und Reaktanz-Ausgangspaaren der zweiten Filtersektion gekoppelt sind; und

   e. eine Anzahl von Z Transkonduktorpaaren, welche die Reaktanzen der ersten Filtersektion über die M Anschlüsse und die Reaktanzen der zweiten Filtersektion über die N Anschlüsse kreuzkoppeln.

2. Aktives Polyphasenfilter mit Transkonduktorkreuzkopplung von Filtersektionen nach Anspruch 1, wobei:

   a. von den M Anschlüssen:

      i) eine Hälfte der M Anschlüsse mit Reaktanz-Eingangspaaren der ersten Filtersektion gekoppelt ist; und
      ii) die andere Hälfte der M Anschlüsse mit Reaktanz-Ausgangspaaren der ersten Filtersektion gekoppelt ist;

   b. von den N Anschlüssen:

      i) eine Hälfte der N Anschlüsse mit Reaktanz-Eingangspaaren der zweiten Filtersektion gekoppelt ist; und
      ii) die andere Hälfte der N Anschlüsse mit Reaktanz-Ausgangspaaren der zweiten Filtersektion gekoppelt ist; und

   c. von den Z Transkonduktorenpaaren:

      i) jeder der Transkonduktoren ein Transkonduktor-Eingangspaar und ein Transkonduktor-Ausgangspaar hat; und
      ii) in jedem Transkonduktorpaar:

         (1) ein Transkonduktor gekoppelt ist durch:

            (a) sein Transkonduktor-Eingangspaar über ein ausgewähltes Paar der M Anschlüsse mit einem Reaktanz-Ausgangspaar einer entsprechenden der X Reaktanzen; und

(b) sein Transkonduktor-Ausgangspaar über ein ausgewähltes Paar der N Anschlüsse mit einem Reaktanz-Eingangspaar einer entsprechenden der Y Reaktanzen; und

(2) der andere Transkonduktor gekoppelt ist durch:

(a) sein Transkonduktor-Eingangspaar über ein ausgewähltes Paar der N Anschlüsse mit einem Reaktanz-Ausgangspaar einer entsprechenden der Y Reaktanzen; und
(b) sein Transkonduktor-Ausgangspaar über ein ausgewähltes Paar der M Anschlüsse mit einem Reaktanz-Eingangspaar einer entsprechenden der X Reaktanzen.

3. Aktives Polyphasenfilter mit Transkonduktorkreuzkopplung von Filtersektionen nach Anspruch 1, wobei die Transkonduktoren aktive symmetrische Gm-Zellen sind.

4. Aktives Polyphasenfilter mit Transkonduktorkreuzkopplung von Filtersektionen nach Anspruch 1, wobei die Transkonduktanz mindestens eines Transkonduktors vor Ort einstellbar ist.

5. Aktives Polyphasenfilter mit Transkonduktorkreuzkopplung von Filtersektionen nach Anspruch 1, wobei

a. die erste Filtersektion und die zweite Filtersektion beide Gauß-Zweiphasen-Tiefpaßfilter dritter Ordnung sind; und
b. der Wert von

i) X und Y gleich ist;
ii) M und N gleich ist; und
iii) M vier mal dem Wert von X ist.

6. Aktives Polyphasenfilter mit Transkonduktorkreuzkopplung von Filtersektionen nach Anspruch 1, wobei

a. die erste Filtersektion und die zweite Filtersektion beide Gauß-Zweiphasen-Tiefpaßfilter sechster Ordnung sind; und
b. der Wert von

i) X, Y und Z gleich ist;
ii) M und N gleich ist; und
iii) M vier mal dem Wert von X ist.

7. Aktives Polyphasenfilter mit Transkonduktorkreuzkopplung von Filtersektionen nach Anspruch 1, wobei:

a. die aktiven symmetrischen Integrierglieder bestehen aus:

i) einem symmetrischen Differenzverstärker, der zwischen das Reaktanz-Eingangspaar und das Reaktanz-Ausgangspaar gekoppelt ist; und
ii) ein abgestimmtes Kondensatorenpaar, wobei:

(1) ein abgestimmter Kondensator parallel geschaltet wird zwischen:

(a) den ersten Eingang des Reaktanz-Eingangspaares; und
(b) den ersten Ausgang des Reaktanz-Ausgangspaares; und

(2) der andere abgestimmte Kondensator parallel geschaltet wird zwischen:

(a) den zweiten Eingang des Reaktanz-Eingangspaares; und
(b) den zweiten Ausgang des Reaktanz-Ausgangspaares;

b. die abgestimmten Kondensatoren der ersten bis Xten Reaktanz und die entsprechenden abgestimmten Kondensatoren der ersten bis Yten Reaktanz die gleiche Kapazität haben; und
c. die Transkonduktanz jedes Transkonduktorpaares festgelegt ist als das Produkt aus:

i) einer gewünschten Mittenkreisfrequenz; und

ii) der Kapazität des nächsten abgestimmten Kondensators, der mit dem Transkonduktorpaar gekoppelt ist.

**8.** Aktives Filter, das aufweist:

a. eine erste Filtersektion mit mehreren ersten Reaktanzen;

b. eine zweite Filtersektion mit mehreren zweiten Reaktanzen, wobei die erste und zweite Mehrzahl von Reaktanzen die gleiche Anzahl aufweisen;

c. mehrere Transkonduktorpaare, wobei jedes Paar einer der mehreren ersten Reaktanzen und einer der mehreren zweiten Reaktanzen entspricht, wobei ein erster Transkonduktor jedes Paares ein Paar Eingänge mit dem entsprechenden der ersten mehreren Reaktanzen gekoppelt hat und ein Paar Ausgänge mit dem entsprechenden der mehreren zweiten Reaktanzen gekoppelt hat und wobei ein zweiter Transkonduktor jedes Paares ein Paar Eingänge mit der entsprechenden der mehreren zweiten Reaktanzen gekoppelt hat und ein Paar Ausgänge mit der entsprechenden der mehreren ersten Reaktanzen gekoppelt hat.

**9.** Aktives Filter nach Anspruch 8, wobei jeder Transkonduktor eine symmetrische Gm-Zelle ist.

**10.** Aktives Filter nach Anspruch 8, wobei jede Reaktanz der mehreren ersten und zweiten Reaktanzen einen Differenzverstärker mit kapazitiver Rückkopplung aufweist.

**11.** Aktives Filter nach Anspruch 8, wobei jede Reaktanz der mehreren ersten und zweiten Reaktanzen ein symmetrisches Integrierglied aufweist.

**12.** Aktives Filter nach Anspruch 8, wobei das aktive Filter ein Quadratur-Polyphasenfilter ist.

**13.** Aktives Filter nach Anspruch 8, wobei das aktive Filter ein Filter dritter Ordnung ist.

**14.** Aktives Filter nach Anspruch 8, wobei das aktive Filter ein Filter sechster Ordnung ist.

**Revendications**

**1.** Filtre actif polyphasé avec couplage croisé de transconducteur entre les parties du filtre, comprenant :

a. des première à quatrième entrées ($I_{IN}$, $Q_{IN}$) pour l'application d'un signal d'entrée quadriphasé comprenant des premier à quatrième vecteurs de signe, respectivement, se succédant les uns aux autres en phase à 90 degrés ;

b. des première à quatrième sorties ($I_{OUT}$, $Q_{OUT}$) ;

c. une première partie de filtre (FB) comprenant :

i) un nombre de X réactances dans lesquelles :

(1) chacune des X réactances sont des circuits intégrants actifs équilibrés (2) comportant une paire d'entrée de réactance

(3) et une paire de sortie de réactance (4) et

(2) chaque X réactance est couplée à la première entrée, la troisième entrée, la première sortie et la troisième sortie ; et

ii) un nombre de M terminaux couplés sélectivement aux paires d'entrée de réactance de la première partie de filtre et aux paires de sortie de réactance de la première partie de filtre ;

d. une seconde partie de filtre (FB1) comprenant :

i) un nombre de Y réactances dans lesquelles :

(1) chacune des Y réactances sont des circuits intégrants actifs équilibrés comportant une paire d'entrée de réactance et une paire de sortie de réactance ; et

(2) chaque Y réactance est couplée à la seconde entrée, la quatrième entrée, la seconde sortie et la quatrième sortie ; et

ii) un nombre de N terminaux couplés sélectivement aux paires d'entrée de réactance de la seconde partie de filtre et aux paires de sortie de réactance de la seconde partie de filtre ; et

e. un nombre de paires de Z transconducteurs assurant un couplage croisé des réactances de la première partie de filtre via les M terminaux et des réactances de la seconde partie de filtre via les N terminaux.

2. Filtre actif polyphasé avec couplage croisé de transconducteur entre les parties du filtre selon la revendication 1, dans lequel :

a. dans les M terminaux :

i) une moitié des M terminaux est couplée aux paires d'entrée de réactance de la première partie de filtre ; et
ii) l'autre moitié des M terminaux est couplée aux paires de sortie de réactance de la première partie de filtre ;

b. dans les N terminaux :

i) une moitié des N terminaux est couplée aux paires d'entrée de réactance de la seconde partie de filtre ; et
ii) l'autre moitié des N terminaux est couplée aux paires de sortie de réactance de la seconde partie de filtre ; et

c. dans les paires de Z transconducteurs :

i) chacun des transconducteurs comprend une paire d'entrée de transconducteur et une paire de sortie de transconducteur ; et
ii) dans chaque paire de Z transconducteur :

(1) un transconducteur est couplé par :

(a) sa paire d'entrée de transconducteur à une paire de sortie de réactance d'une X réactance correspondante par le biais d'une paire sélectionnée des M terminaux ; et
(b) sa paire de sortie de transconducteur à une paire d'entrée de réactance d'une Y réactance correspondante par le biais d'une paire sélectionnée des N terminaux ; et

(2) l'autre transconducteur est couplé par :

(a) sa paire d'entrée de transconducteur à une paire de sortie de réactance d'une Y réactance correspondante par le biais d'une paire sélectionnée des N terminaux ; et
(b) sa paire de sortie de transconducteur à une paire d'entrée de réactance d'une X réactance correspondante par le biais d'une paire sélectionnée des M terminaux.

3. Filtre actif polyphasé avec couplage croisé de transconducteur entre les parties du filtre selon la revendication 1, dans lequel les transconducteurs sont des cellules Gm actives équilibrées.

4. Filtre actif polyphasé avec couplage croisé de transconducteur entre les parties du filtre selon la revendication 1, dans lequel la tranaconductance d'au moins un transconducteur est réglable par l'utilisateur.

5. Filtre actif polyphasé avec couplage croisé de transconducteur entre les parties du filtre selon la revendication 1, dans lequel :

a. la première partie de filtre et la seconde partie de filtre sont toutes les deux des filtres gaussiens biphasés passe-bas de troisième ordre ; et
b. la valeur de :

i) X et la valeur de Y sont égales ;
ii) M et la valeur de N sont égales ; et
iii) M est égale à quatre fois celle de X.

**6.** Filtre actif polyphasé avec couplage croisé de transconducteur entre les parties du filtre selon la revendication 1, dans lequel :

a. la première partie de filtre et la seconde partie de filtre sont toutes les deux des filtres gaussiens biphasés passe-bas de sixième ordre ; et
b, la valeur de :

i) X et les valeurs de Y et Z sont égales ;
ii) M et la valeur de N sont égales ; et
iii) M est égale à quatre fois celle de X.

**7.** Filtre actif polyphasé avec couplage croisé de transconducteur entre les parties du filtre selon la revendication 1, dans lequel :

a. les circuits intégrants actifs équilibrés sont composés :

i) d'un amplificateur différentiel équilibré couplé entre la paire d'entrées de réactance et la paire de sorties de réactance ; et
ii) une paire de condensateurs appariés, dans laquelle :

(1) un condensateur apparié est dérivé entre :

(a) la première entrée de la paire d'entrée de réactance ; et
(b) la première sortie de la paire de sortie de réactance ; et

(2) l'autre condensateur apparié est dérivé entre :

(a) la seconde entrée de la paire d'entrée de réactance ; et
(b) la seconde sortie de la paire de sortie de réactance ;

b. les condensateurs appariés de la première à la $X^{\text{ème}}$ réactance et les condensateurs appariés correspondants de la première à la $Y^{\text{ème}}$ réactance ont une capacitance égale ; et
c. la transconductance de chaque paire de transconducteur est définie comme le produit résultant :

i) d'une fréquence radiale médiane souhaitée ; et
ii) de la capacitance des condensateurs appariés les plus proches, couplés à la paire de transconducteurs.

**8.** Filtre actif comprenant :

a. une première partie de filtre comportant une première pluralité de réactances ;
b. une seconde partie de filtre comportant une seconde pluralité de réactances dans laquelle la première et la seconde pluralité de réactances comprennent des nombres égaux ;
c. une pluralité de paires de transconducteurs, chaque paire correspondant à une paire de la première pluralité de réactances et à une paire de la seconde pluralité de réactances, un premier transconducteur de chaque paire comprenant une paire d'entrées couplée à la paire correspondante de la première pluralité de réactances, et une paire de sorties couplée à la paire correspondante de la seconde pluralité de réactances et un second transconducteur de chaque paire comprenant une paire d'entrées couplée à la paire correspondante de la seconde pluralité de réactances et une paire de sorties couplée à la paire correspondante de la première pluralité de réactances.

**9.** Filtre actif selon la revendication 8, dans lequel chaque transconducteur est une cellule Gm équilibrée.

**10.** Filtre actif selon la revendication 8, dans lequel chaque réactance de la première et de la seconde pluralité de réactances comprend un amplificateur différentiel à réaction capacitive.

**11.** Filtre actif selon la revendication 8, dans lequel chaque réactance de la première et de la seconde pluralité de réactances comprend un intégrateur équilibrée.

**12.** Filtre actif selon la revendication 8, dans lequel le filtre actif est un filtre polyphasé en quadrature.

**13.** Filtre actif selon la revendication 8, dans lequel le filtre actif est un filtre de troisième ordre.

**14.** Filtre actif selon la revendication 8, dans lequel le filtre actif est un filtre de sixième ordre.

Fig. 1A (PRIOR ART)

*Fig. 1b* (PRIOR ART)

*Fig. 1C* (PRIOR ART)

Fig. 1D (PRIOR ART)

Fig. 1E   (PRIOR ART)

EP 1 245 080 B1

+I$_{IN}$ — IZA

-I$_{IN}$ — IZB

FBZ

OZA — +Iout

OZB — -Iout

TZ1  TZ2  TZ3  TZ4  TZ5  TZ6

A-D  A-D  A-D  A-D  A-D  A-D

*Fig. 1F* (PRIOR ART)

*Fig. 2A* (PRIOR ART)

*Fig. 2B*  (PRIOR ART)

R BLOCK

Fig. 3A (PRIOR ART)

EP 1 245 080 B1

*Fig. 3B*   (PRIOR ART)

R BLOCK

*Fig. 3C*  (PRIOR ART)

*Fig. 3D* (PRIOR ART)

*Fig. 4A* (PRIOR ART)

*Fig. 4B* (PRIOR ART)

Fig. 5A

*Fig. 5B*

G BLOCK

Fig. 5C

EP 1 245 080 B1

A-D       A-D       A-D

GC1       GC2       GC3

G BLOCK

GC1'       GC2'       GC3'

A-D       A-D       A-D

*Fig. 5D*

*Fig. 5E*

GZ BLOCK

*Fig. 5F*

| A-D | A-D | A-D | A-D | A-D | A-D |
|-----|-----|-----|-----|-----|-----|
| GZC1 | GZC2 | GZC3 | GZC4 | GZC5 | GZC6 |

**GZ BLOCK**

| GZC1' | GZC2' | GZC3' | GZC4' | GZC5' | GZC6' |
|-------|-------|-------|-------|-------|-------|
| A-D | A-D | A-D | A-D | A-D | A-D |

*Fig. 5G*

*Fig. 6A*

Fig. 6B